# EUROPEAN PATENT SPECIFICATION

(11) **EP 4 198 576 B1**
(45) Date of publication and mention of the grant of the patent: **29.10.2025**
(21) Application number: 21214549.4
(22) Date of filing: 14.12.2021
(51) Int. Cl.: G01T 1/17, G01T 1/24

(54) **DEFECTIVE PIXEL MANAGEMENT IN CHARGED PARTICLE MICROSCOPY**
VERWALTUNG DEFEKTER PIXEL IN DER LADUNGSTRÄGERTEILCHENMIKROSKOPIE
GESTION DE PIXELS DÉFECTUEUX EN MICROSCOPIE À PARTICULES CHARGÉES

(43) Date of publication of application: 21.06.2023
(73) Proprietor: FEI Company, Hillsboro, OR 97124-5793 (US)
(72) Inventor: Janssen, Bart, 5602 BS Eindhoven (NL); Franken, Erik, 5602 BS Eindhoven (NL); Van der Heide, Auke, 5602 BS Eindhoven (NL)
(74) Representative: Boult Wade Tennant LLP

(56) References cited:
- EP-A1- 3 839 574
- US-A1- 2005 179 675
- US-A1- 2017 020 475

## Description

### Background

Microscopy is the technical field of using microscopes to better view objects that are difficult to see with the naked eye. Different branches of microscopy include, for example, optical microscopy, charged particle (e.g., electron and/or ion) microscopy, and scanning probe microscopy. Charged particle microscopy involves using a beam of accelerated charged particles as a source of illumination. Types of charged particle microscopy include, for example, transmission electron microscopy, scanning electron microscopy, scanning transmission electron microscopy, and ion beam microscopy.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a block diagram of an example charged particle microscope (CPM) support module for performing support operations, in accordance with various embodiments.
FIG. 2 is a block diagram of a CPM system that may include the CPM support module of FIG. 1, in accordance with various embodiments.
FIG. 3 illustrates example defective pixel regions and working pixel regions of a pixel array of a charged particle sensor that may be identified by the CPM support module of FIG. 1, in accordance with various embodiments.
FIG. 4A is a CPM output intensity profile that may be representative of the output of charged particle detection logic of the CPM support module of FIG. 1, in accordance with various embodiments.
FIG. 4B is a CPM output intensity profile that may be representative of the output of the defect masking logic of the CPM support module of FIG. 1, in accordance with various embodiments.
FIG. 5 is a table of example charged particle event indicators that may be output by the CPM support module of FIG. 1, in accordance with various embodiments.
FIGS. 6-9 are flow diagrams of example methods of performing CPM support operations, in accordance with various embodiments.
FIG. 10 is an example of a graphical user interface that may be used in the performance of some or all of the CPM support methods disclosed herein, in accordance with various embodiments.
FIG. 11 is a block diagram of an example computing device that may perform some or all of the CPM support methods disclosed herein, in accordance with various embodiments.
FIG. 12 is a block diagram of an example CPM support system in which some or all of the CPM support methods disclosed herein may be performed, in accordance with various embodiments.

### Detailed Description

Disclosed herein are methods, apparatuses, systems, and computer-readable media related to defective pixel management in charged particle microscopy. For example, in some embodiments, a charged particle microscope (CPM) support apparatus may: identify a working pixel region of a charged particle camera, wherein the working pixel region is proximate to a defective pixel region in which the charged particle camera cannot detect charged particle events; generate a set of charged particle event indicators that represent a charged particle event in the working pixel region; adjust the set of charged particle event indicators so that a charged particle event intensity over the working pixel region is not significantly greater than a charged particle event intensity over the defective pixel region; and output charged particle event data, wherein the charged particle event data includes data representative of the adjusted set of charged particle event indicators.

The CPM support embodiments disclosed herein may achieve improved performance relative to conventional approaches. In conventional microscopy systems, camera defects (e.g., defect rows, columns, clusters and/or single pixel defects) are masked in camera firmware by applying image interpolation at the defect pixels using neighboring pixel value information. However, such interpolations are typically performed after transforming the stream of charged particle positions into an image representation, and thus defect information must be provided to the (typically third-party) software that performs the decoding and subsequent reconstruction. Additionally, because such interpolation typically requires processing the charged particle data into an image in advance, no such interpolation could be performed on data that is still in the "raw" charged particle position form (e.g., electron event representation (EER) data). Further, the negative effects of camera defects are not limited only to errors in the output of particular defect pixels, but extend to proximate pixels. For example, a working pixel in the neighborhood of a defect pixel may register an artificially high number of charged particle events as spurious "overflow" from charged particle events not properly registered by the defect pixel. When a defective line of pixels is present, for example, this overflow effect may present as a "bright line" of pixels next to the defective line. In another example, subpixel localization (a process by which the location of a charged particle event is localized to a resolution below the pixel resolution based on, e.g., the area over which charge carriers are generated in a complementary metal oxide semiconductor (CMOS) sensor of the camera) performed in the neighborhood of defective pixels may exhibit a bias in which some subpixels are preferentially and spuriously identified as the appropriate subpixel location for a charged particle event. When a defective line of pixels is present, for example, this subpixel localization bias may take the form of one or more bright subpixel lines corresponding to the nearest subpixels in one or more of the neighboring lines of pixels (e.g., two bright subpixel lines at the subpixels, closest to the defective line, of the neighboring lines of pixels). Such subpixel localization bias may also occur for charged particle events detected proximate to the edges of a pixel array, even when there are no defective proximate pixels; thus, the term "defective pixel region" also refers to the areas outside the borders of a pixel array, so that any of the defective pixel mitigation techniques disclosed herein may be applied to the pixels proximate to the edge of a pixel array, in addition to or instead of to the pixels proximate to pixels that do not function properly. US 2017/020475 A1 discloses an X-ray based microscope support apparatus, comprising: first logic to identify a working pixel region, wherein the working pixel region is proximate to a defective pixel region; second logic to generate a first event indicator and a second event indicator; third logic to select the second charged particle event indicator for correcting data of the first event indicator; and fourth logic to output event data, wherein the event data includes data representative of the first charged particle event indicator.

The CPM support embodiments disclosed herein may mask defects in a charged particle camera by mitigating the spurious overflow and/or the spurious subpixel localization of charged particle events arising proximate to camera defects (and camera edges, which may be treated as camera defects for the purposes of the application of the techniques disclosed herein). Spurious overflow effects may be mitigated by discarding a fraction of charged particle events detected in a working pixel region proximate to a defective pixel region; the fraction discarded may be a function of the size of the defective pixel region and/or an expected rate of charged particle events detected by the working pixel region (e.g., an estimate of the local charged particle radiation dose rate). Spurious subpixel localization may be mitigated by assigning a charged particle event at a particular pixel location to another selected subpixel at that location (selected, e.g., probabilistically and/or uniformly from among the subpixels). These mitigation techniques may be performed in conjunction with generating "mask" charged particle event indicators associated with defect pixel locations. Such techniques may be implemented in the hardware of the charged particle camera itself, if desired, and allows the resulting data stream to be processed by third-party or other reconstruction software as if the data were defect-free. Various ones of the embodiments disclosed herein permit defect information to be provided separately to downstream software, when desired, and achieve improved reconstruction by mitigating the presence of defects (e.g., by reducing the likelihood that shift detection, multi-image alignment, or other processes will be undesirably influenced by defects). The embodiments disclosed herein thus provide improvements to CPM technology (e.g., improvements in the computer technology supporting such CPMs, among other improvements).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the subject matter disclosed herein. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

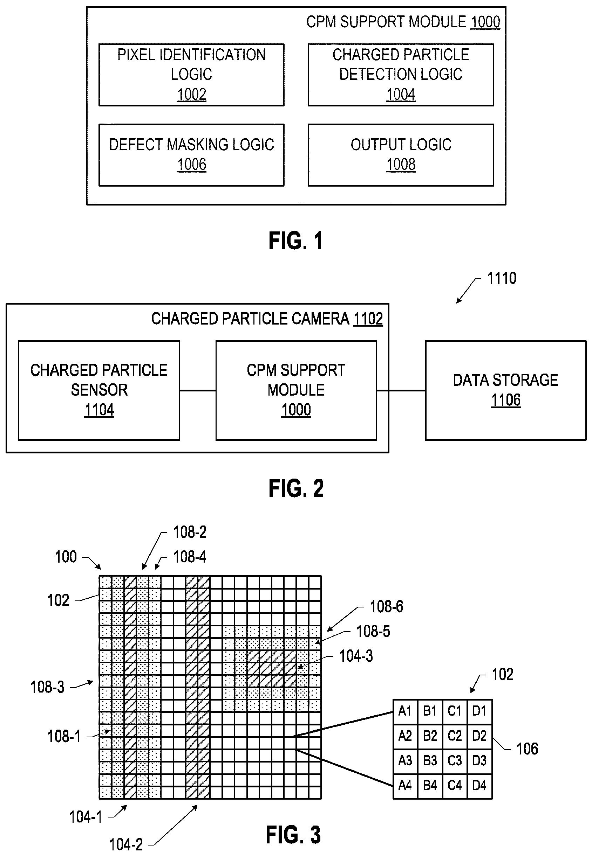

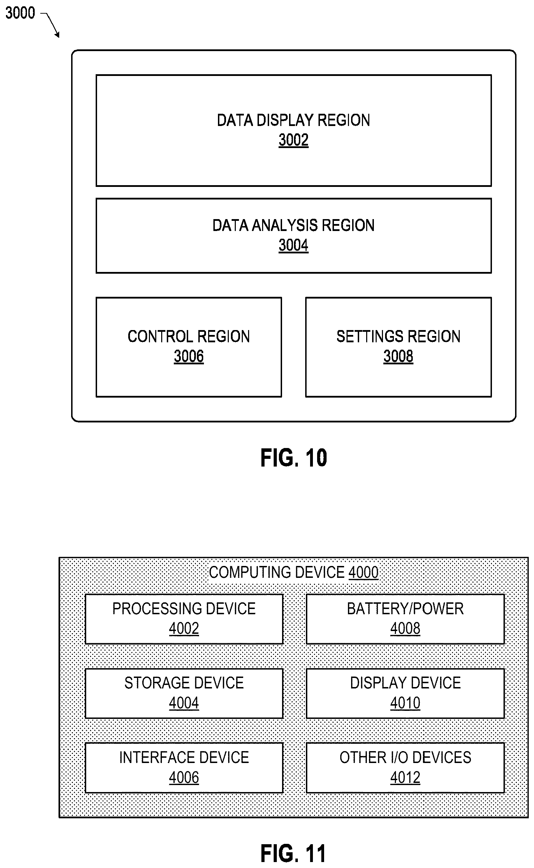

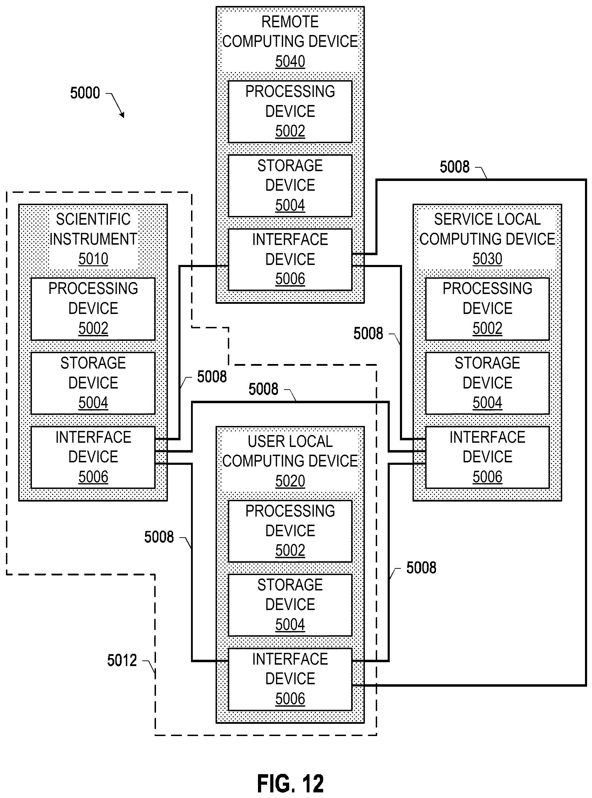

FIG. 1 is a block diagram of a CPM support module 1000 for performing support operations, in accordance with various embodiments. The CPM support module 1000 may be implemented by circuitry (e.g., including electrical and/or optical components), such as a programmed computing device. The logic of the CPM support module 1000 may be included in a single computing device, or may be distributed across multiple computing devices that are in communication with each other as appropriate. Examples of computing devices that may, singly or in combination, implement the CPM support module 1000 are discussed herein with reference to the computing device 4000 of FIG. 11, and examples of systems of interconnected computing devices, in which the CPM support module 1000 may be implemented across one or more of the computing devices, is discussed herein with reference to the CPM support system 5000 of FIG. 12. The CPM whose operations are supported by the CPM support module 1000 may include any suitable type of CPM, such as a scanning electron microscope (SEM), a transmission electron microscope (TEM), a scanning transmission electron microscope (STEM), or an ion beam microscope.

The CPM support module 1000 may include pixel identification logic 1002, charged particle detection logic 1004, defect masking logic 1006, and output logic 1008. As used herein, the term "logic" may include an apparatus that is to perform a set of operations associated with the logic. For example, any of the logic elements included in the CPM support module 1000 may be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" may refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module may not include all of the logic elements depicted in the associated drawing; for example, a module may include a subset of the logic elements depicted in the associated drawing when that module is to perform a subset of the operations discussed herein with reference to that module. In some particular embodiments, the CPM support module 1000 may be implemented by programmed field programmable gate arrays (FPGAs) that may be part of a charged particle camera.

The pixel identification logic 1002 may be configured to identify one or more defective pixel regions 104 of a charged particle camera 1102 (e.g., a charged particle counting camera, such as an electron counting camera) and one or more working pixel regions 108 of the charged particle camera 1102. As used herein, a "defective pixel region" 104 of a charged particle camera 1102 may include one or more pixels that, unlike other "working" or "non-defective" pixel regions 108 of the charged particle camera, are unable to properly detect charged particle events. FIG. 2 is a block diagram of a CPM system 1110 that includes a charged particle camera 1102 communicatively coupled to a data storage 1106 (e.g., multiple hard drives). During use, the charged particle camera 1102 may be used as part of a CPM (e.g., the CPM 5010 discussed below with reference to FIG. 12) to image a specimen, and the CPM support module 1000 may generate data (to be stored in the data storage 1106) representative of charged particle events in this imaging. Data stored in the data storage 1106 may be accessible by reconstruction logic that may perform single particle analysis (SPA), tomographic reconstruction, or any other suitable reconstruction technique using the data generated by the charged particle camera 1102 to reconstruct the microscopic structure of the specimen. In the CPM system 1110, the charged particle camera 1102 may include a charged particle sensor 1104 communicatively coupled to a CPM support module 1000 (e.g., any of the CPM support modules 1000 disclosed herein). The charged particle sensor 1104 may take any suitable form for detecting appropriate charged particles. For example, in some embodiments, the charged particle sensor 1104 may include CMOS sensor pixels for electron detection. The pixel identification logic 1002 of a CPM support module 1000 may identify one or more defective pixel regions 104 and one or more working pixel regions 108 of the charged particle sensor 1104 of a charged particle camera 1102, and may store the identification of the one or more defective pixel regions 104 and the one or more working pixel regions 108 in a memory accessible by the pixel identification logic 1002 (e.g., as discussed below with reference to FIG. 3, the pixel identification logic 1002 may store identifiers of which pixels 102 in a pixel array 100 are in particular defective pixel regions 104 and which pixels 102 in a pixel array 100 are in particular working pixel regions 108).

FIG. 3 illustrates example defective pixel regions 104 of a pixel array 100 (made up of individual pixels 102) of a charged particle sensor 1104 that may be identified by the pixel identification logic 1002, in accordance with various embodiments. FIG. 3 illustrates three particular example defective pixel regions 104: a defective pixel region 104-1 that includes a column of defective pixels 102 (also referred to as a "column defect," an example of a "line defect"), a defective region 104-2 that includes two adjacent columns of defective pixels 102 (also referred to as a "double column defect"), and a defective region 104-3 that includes a rectangular 3 x 4 array of defective pixels 102 (also referred to as an "area defect"). A row of defective pixels 102 (not shown) may also be a defective pixel region 104, and is another example of a line defect. The particular number, arrangement, and sizes of the defective pixel regions 104 in FIG. 3 is simply illustrative, and a charged particle camera 1102 may include any number and arrangement of defective pixel regions 104. For example, in some embodiments, a defective pixel region 104 may include a single pixel 102, and/or one or more non-rectangular areas of pixels 102.

FIG. 3 also illustrates example working pixel regions 108 of a pixel array 100 of a charged particle sensor 1104 that may be identified by the pixel identification logic 1002, in accordance with various embodiments. FIG. 3 illustrates six particular example working pixel regions 108: working pixel regions 108-1 and 108-2, which are on opposites sides of and adjacent to the "column defect" defective region 104-1; working pixel regions 108-3 and 108-4, which are on opposite sides of and not adjacent to the "column defect" defective region 104-1; working pixel region 108-5, which is surrounding and adjacent to the "area defect" defective region 104-3; and working pixel region 108-6, which is surrounding and not adjacent to the "area defect" defective region 104-3. One or more working pixel regions 108 may also be proximate to the defective pixel region 104-2, but are not shown for clarity of illustration. Note that a defective pixel region 104 may have zero proximate working pixel regions 108 identified by the pixel identification logic 1002 (e.g., when no defect masking in proximate working pixels is desired for a particular defective pixel region 104), one proximate working pixel region 108 (e.g., if the working pixel region 108-5, but not the working pixel region 108-6, was identified proximate to the defective pixel region 104-3), two proximate working pixel regions 108 (e.g., as shown in FIG. 3 proximate to the defective pixel region 104-3), or more than two proximate working pixel regions 108 (e.g., as shown in FIG. 3 proximate to the defective pixel region 104-1). The working pixel regions 108 proximate to a defective pixel region 104 need not be within one or two pixels distance from the defective pixel region 104, but may be identified by the pixel identification logic 1002 at any pixel distance from a defective pixel region 104 at which defect masking techniques are to be applied. Further, the working pixel regions 108 identified by the pixel identification logic 1002 need not include all working pixels of a pixel array 100, only those to which defect masking techniques in accordance with the present disclosure are to be applied.

FIG. 3 also illustrates an example arrangement of subpixels 106 of a pixel 102 of the pixel array 100. In the particular example of FIG. 3, a pixel 102 may include 16 subpixels 106, arranged as a 4-by-4 grid with columns identified by letters (i.e., "A", "B," "C," and "D") and rows identified by numbers (i.e., "1," "2," "3," and "4"). Other arrangements of subpixels 106 (e.g., 2-by-2 arrangements, 3-by-3 arrangements, 5-by-5 arrangements, etc.) in a pixel 102 may be used.

In some embodiments, the pixel identification logic 1002 may store the identification of defective pixel regions 104 and/or working pixel regions 108 of a charged particle camera 1102 when the charged particle camera 1102 is manufactured or initially sold. For example, during manufacturing or test, defective pixel regions 104/working pixel regions 108 of a charged particle sensor 1104 may be identified, and the pixel identification logic 1002 may store information regarding these defective pixel regions 104/working pixel regions 108. In some embodiments, the pixel identification logic 1002 may "update" or otherwise store new information about defective pixel regions 104/working pixel regions 108 of a charged particle camera 1102 after commencement of operation of the charged particle camera 1102. For example, the pixel identification logic 1002 may perform periodic tests of the pixels 102 of a pixel array 100 of a charged particle sensor 1104, and when pixels 102 are newly identified (or confirmed) as defective (e.g., due to radiation damage or other deterioration), the pixel identification logic 1002 may update the stored list or other identification of the defective pixel regions 104 accordingly. Similarly, the pixel identification logic 1002 may perform periodic tests of the pixels 102 of a pixel array 100 of a charged particle sensor 1104, and when pixels 102 are newly identified (or confirmed) as being affected by spurious detected charged particle events and/or by spurious subpixel localization, the pixel identification logic 1002 may update the stored list or other identification of the working pixel regions 108 accordingly. In this manner, the pixel identification logic 1002 may continue to monitor the pixels 102 for defects and spurious effects during the lifetime of the charged particle camera 1102.

The charged particle detection logic 1004 may be configured to generate charged particle event indicators based on charged particle events detected by the working pixels 102 of the pixel array 100 of a charged particle sensor 1104. When a charged particle event is detected by a working pixel 102, the charged particle detection logic 1004 may receive information about this charged particle event from the charged particle sensor 1104 (e.g., via a fiber-optic cable or other communication link), and in response, the charged particle detection logic 1004 may generate a charged particle event indicator representative of this charged particle event. In particular, the charged particle event indicator identifies a time and a location of the charged particle event. In some embodiments, the time of a charged particle event indicator may be a frame interval N, representative of the associated charged particle event happening during the frame interval associated with the capture of the Nth frame of pixel array data; combining the frame number N with the frame rate may allow a time (e.g., in the unit of seconds) to be identified. In some embodiments, the location of a charged particle event indicator may reflect the particular pixel 102 and subpixel 106 at which the associated charged particle event was detected. The pixel 102 and subpixel 106 location of a charged particle event indicator may be determined based on signals generated by the charged particle sensor 1104. For example, a charged particle event (e.g., an electron event) causes charge carriers to be generated across an area of the charged particle sensor 1104. The centroid or other property of this area may be calculated in accordance with any suitable known technique to estimate a location for the charged particle event to subpixel accuracy. Charged particle event indicators generated by the charged particle detection logic 1004 may include other charged particle event information in addition to time and location, as desired.

The defect masking logic 1006 may be configured to modify the set of charged particle event indicators generated by the charged particle detection logic 1004 to mitigate the spurious effects of the defective pixel regions 104 on the output of the charged particle sensor 1104. In some embodiments, to mitigate the spurious overflow charged particle events detected in one or more of the working pixel regions 108, the defect masking logic 1006 may be configured to select some of the set of charged particle event indicators generated by the charged particle detection logic 1004 in the working pixel regions 108 for discarding. For example, the defect masking logic 1006 may select a fraction of the set of charged particle event indicators in a working pixel region 108 for discarding, with the magnitude of that fraction representative of the estimated amount of "spillover" events from a proximate defective pixel region 104. The magnitude of this fraction for a particular working pixel region 108 may be a function of the size of the proximate defective pixel region 104 (e.g., with "double column" defective pixel regions 104 resulting in more spurious spillover into neighboring working pixel regions 108 than "single column" defective pixel regions 104). In addition to or instead of a function of the size of the proximate defective pixel region 104, the magnitude of the discarding fraction for a particular working pixel region 108 may be a function of an estimate of the local charged particle radiation dose rate or other measure of the expected rate of charged particle events detected by the working pixel region 108 (e.g., with a greater discarding fraction used for greater local charged particle radiation dose rates). The particular functions governing the discarding fraction may, in some embodiments, be determined by irradiating a charged particle sensor 1104 with a uniform charged particle radiation at different dose rates, and measuring the number of spillover charged particle events in a particular working pixel region 108 (by comparing the measured number of charged particle events to the expected number of charged particle events), and setting the discarding fraction for that working pixel region 108 to compensate accordingly. Note that the defect masking logic 1006 may store and apply different discarding fractions (and the functions that govern them) for different ones of the working pixel regions 108 in a pixel array 100.

In addition to or instead of mitigating spurious overflow of charged particle events in working pixel regions 108, the defect masking logic 1006 may be configured to generate an subpixel location for a charged particle event detected by the charged particle detection logic 1004 to mitigate spurious subpixel localization bias due to proximate defective pixel regions 104. For example, in some embodiments, the defect masking logic 1006 may receive a charged particle event indicator (including a location of a pixel 102 associated with the charged particle event) from the charged particle detection logic 1004, and may probabilistically or deterministically select from the subpixels 106 of the pixel 102 to and may set the selected subpixel 106 as the subpixel location associated with the charged particle event indicator. Whether probabilistic or deterministic, in some embodiments, the defect masking logic 1006 may select from among the subpixels 106 of a pixel 102 uniformly (matching the expected spatial distribution arising from a Poisson process model of the charged particle events) or using another distribution. The selected subpixel 106 may replace a subpixel initially associated with the charged particle event (generated by the charged particle detection logic 1004 using a conventional technique, such as a centroid technique) or may provide the initial subpixel location for the charged particle event. The defect masking logic 1006 may store any selection rules for subpixel localization associated with different ones of the working pixel regions 108 and apply these rules to charged particle events detected in the working pixel regions 108 by the charged particle detection logic 1004.

The defect masking logic 1006 may also be configured to generate charged particle event indicators, but these charged particle event indicators may not correspond to "detected" charged particle events detected by a charged particle camera 1102. Instead, the defect masking logic 1006 may generate "mask" (or "fake") charged particle event indicators associated with locations within one or more of the defective pixel regions 104.

The defect masking logic 1006 may generate the charged particle event indicators for a defective pixel 102 based on an estimate of the local charged particle radiation dose rate at the defective pixel 102, and such an estimate may rely on the "detected" charged particle events occurring at working pixels 102 of a charged particle camera 1102. Thus, the defect masking logic 1006 may generate charged particle event indicators based on the charged particle events occurring at the working pixels 102. In some embodiments, the defect masking logic 1006 may apply deterministic criteria to generate charged particle event indicators based on the charged particle events occurring at the working pixels 102 of a charged particle camera 1102. For example, the defect masking logic 1006 may generate a "mask" charged particle event indicator whose location corresponds to a defective pixel 102 when a majority of the working pixels 102 closest to the defective pixel 102 detect a charged particle event (e.g., within a single frame interval or other time period). The deterministic criteria that may be applied by the defect masking logic 1006 may be chosen in any desired manner.

In some embodiments, the defect masking logic 1006 may apply probabilistic criteria to generate charged particle event indicators based on the charged particle events occurring (and not occurring) at the working pixels 102 of the charged particle camera 1102. For example, the defect masking logic 1006 may generate a "mask" charged particle event indicator whose location corresponds to a defective pixel 102 with a probability that increases with the number of neighboring (e.g., one or more spatially neighboring or otherwise proximate and/or temporally neighboring or otherwise proximate) working pixels 102 that detected a charged particle event (e.g., within a single frame interval or other time).

The defect masking logic 1006 may implement any suitable deterministic criteria, probabilistic criteria, and/or combination of deterministic criteria and probabilistic criteria for generating the "mask" charged particle event indicators. For example, the defect masking logic 1006 may apply a probabilistic rule for the generation of a charged particle event indicator for a defective pixel 102 in which the "influence" of charged particle events happening at working pixels 102 decreases as the distance between the defective pixel 102 and the working pixel 102 increases. Similarly, the defect masking logic 1006 may generate "mask" charged particle event indicators for defective pixel regions 104 in one frame interval or other time period based on "detected" charged particle events in a different frame interval or other time period (e.g., temporally "adjacent" frame intervals or other time periods). For example, the defect masking logic 1006 may apply a probabilistic rule for the generation of a charged particle event indicator for a defective pixel 102 at a particular time in which the "influence" of charged particle events happening at working pixels 102 at different times decreases as the temporal distance between the particular time and the different times increases. In this way, the defect masking logic 1006 may generate "mask" charged particle event indicators (including location and time information) for defective pixel regions 104 based on deterministic and/or probabilistic criteria relating to the location of "detected" charged particle events and/or based on deterministic and/or probabilistic criteria relating to the time of "detected" charged particle events.

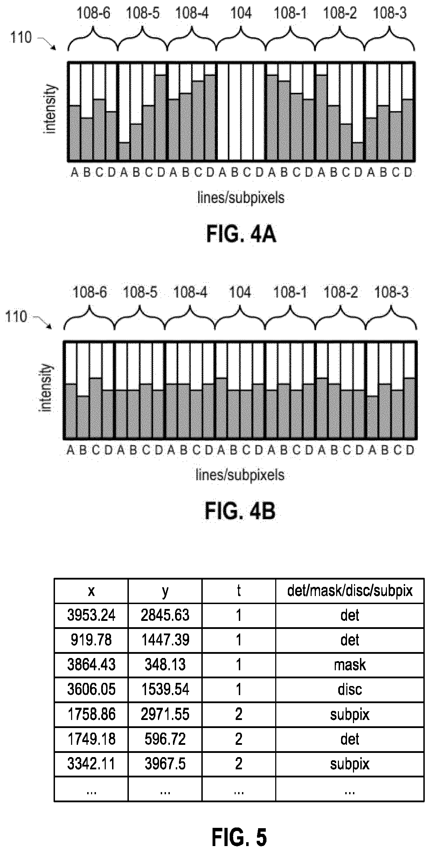

FIG. 4 illustrates an example application of various ones of the defect masking techniques disclosed herein. In particular, FIG. 4A is an "unmasked" CPM output intensity profile 110 that may be representative of the output of the charged particle detection logic 1004 of the CPM support module 1000, and FIG. 4B is a "masked" CPM output intensity profile 110 that may be representative of the output of the defect masking logic 1006 of the CPM support module 1000 based on the CPM output intensity profile 110 of FIG. 4A, in accordance with various embodiments. The CPM output intensity profiles 110 represent a summation of charged particle event counts over the columns of a pixel array like the pixel array 100 of FIG. 2, broken out at subpixel level. The particular example of FIG. 4 illustrates seven adjacent columns of pixels 102, each having subpixel columns labeled "A," "B," "C," and "D," as discussed above with reference to FIG. 2. The particular example of FIG. 4 also illustrates a central defective pixel region 104 (corresponding to a column defect), with working pixel regions 108-1, 108-2, and 108-3 to the right to the defective pixel region 104 (and in order of increasing distance from the defective pixel region 104), and with working pixel regions 108-4, 108-5, and 108-6 to the left to the defective pixel region 104 (and in order of increasing distance from the defective pixel region 104).

In the "unmasked" CPM output intensity profile 110 of FIG. 4A, no charged particle events may be detected in any of the subpixels of the defective pixel region 104, and the working pixel regions 108-1 and 108-4 adjacent to the defective pixel region 104 may exhibit both spurious overflow events (as indicated by the high intensity across all subpixels) and subpixel localization bias (as indicated by the "stairstep" decreasing intensity across subpixels with distance away from the defective pixel region 104). Further, the working pixel regions 108-2 and 108-5 (spaced apart from the defective pixel region 104 by intervening working pixel regions 108-2 and 108-4, respectively) may exhibit subpixel localization bias (as indicated by the "stairstep" decreasing intensity across subpixels with distance away from the defective pixel region 104), but may not exhibit spurious overflow events (e.g., due to their distance away from the defective pixel region 104). The working pixel regions 108-3 and 108-5 may not exhibit either spurious overflow events or subpixel localization bias.

The defect masking logic 1006 may modify the set of charged particle event indicators generated by the charged particle detection logic 1004 (and represented in the CPM output intensity profile 110 of FIG. 4A) to generate a modified set of charged particle event indicators as represented in the CPM output intensity profile 110 of FIG. 4B. In particular, as shown in the "masked" CPM output intensity profile 110 of FIG. 4B, the defect masking logic 1006 may generate "mask" charged particle event indicators for the defective pixel region 104, may discard a fraction of the charged particle event indicators and reassign the subpixel locations for charged particle events detected in the working pixel regions 108-1 and 108-4 (to mitigate the spurious overflow events and subpixel localization bias, respectively), and may reassign the subpixel locations for charged particle events detected in the working pixel regions 108-2 and 108-5 (to mitigate the subpixel localization bias). When the working pixel regions 108-3 and 108-5 do not significantly exhibit either spurious overflow events or subpixel localization bias, the defect masking logic 1006 may not modify charged particle event indicators generated by the charged particle detection logic 1004 in those working pixel regions 108.

The output logic 1008 may be configured to output data representative of the set of charged particle event indicators generated by the charged particle detection logic 1004 in conjunction with the defect masking logic 1006. For example, FIG. 5 is a table of example charged particle event indicators (corresponding to the rows of the table) that may be output by the output logic 1008, in accordance with various embodiments. Each of the charged particle event indicators depicted in FIG. 5 includes location information (i.e., the x and y coordinates, representative of a location specified to subpixel location) and time information (i.e., a frame number). In some embodiments, the charged particle event indicators provided by the output logic 1008 may also include an indicator of whether the charged particle event indicator corresponds to a "detected" charged particle event (i.e., was generated by the charged particle detection logic 1004), to a "mask" charged particle event (i.e., was generated by the defect masking logic 1006), a "discarded" charged particle event (i.e., was part of the fraction of charged particle events detected in a working pixel region 108 and discarded by the defect masking logic 1006), or a "subpixel re-localized" charged particle event (i.e., had its subpixel location generated by the defect masking logic 1006 to mitigate subpixel localization bias). For example, the charged particle event indicators of FIG. 5 also include a "det(ected)/mask/disc(arded)/subpix(el re-localized)" indicator, with "det" indicating that the charged particle event indicator corresponds to a "detected" charged particle event, "mask" indicating that the charged particle event indicator corresponds to a "mask" charged particle event, "disc" indicating that the charged particle event indicator corresponds to a discarded charged particle event, and "subpix" indicating that the subpixel location was generated by the defect masking logic 1006. In other embodiments, the charged particle event indicators provided by the output logic 1008 may not include an indicator of whether the charged particle event indicator corresponds to a "detected," "mask," "discarded," and/or "subpixel re-localized" charged particle event. In some embodiments, a charged particle event indicator selected for discarding may not appear in the data output from the output logic 1008. As noted above, in some embodiments, the output logic 1008 may output the charged particle event indicators to reconstruction logic (e.g., via the data storage 1106) that is to use the data to perform SPA, tomographic reconstruction, or other reconstruction techniques and thereby obtain information about the specimen imaged by the charged particle camera 1102.

Charged particle event indicators may be output by the output logic 1008 (e.g., to the data storage 1106 of the CPM system 1110 via an ethernet cable or any other suitable communication link) in any of a number of ways. In some embodiments, the data output by the output logic 1008 may include a charged particle event representation data (e.g., electron event representation (EER) data). In some embodiments, the output logic 1008 may stream the charged particle event indicators as they are generated by the charged particle detection logic 1004 and the defect masking logic 1006. In some embodiments, the output logic 1008 may queue or buffer the charged particle event indicators (e.g., so the defect masking logic 1006 can generate "mask" charged particle event indicators for a particular time based on "detected" charged particle events happening after that time). The output logic 1008 may encode the charged particle event indicators and any desired manner; for example, the output logic 1008 may output the charged particle event indicators as a stream of packets. In some embodiments, the output logic 1008 may provide a first data stream that includes charged particle event indicators generated by the charged particle detection logic 1004 (i.e., associated with "detected" charged particle events) and a second, different data stream that includes charged particle event indicators generated by the defect masking logic 1006 (i.e., associated with "mask" charged particle events).

Data representative of charged particle event indicators, output by the output logic 1008, may not include the charged particle event indicators themselves. For example, in some embodiments, the output logic 1008 may output an image or other summary of charged particle event indicators; such an image or other summary may represent a collection of charged particle event indicators (detected and/or masked), and may be collected over time such that the particular times associated with the charged particle event indicators is not represented in the image or other summary. Further, data representative of charged particle event indicators may also represent further processing performed on the charged particle event indicators. For example, the data output by the output logic 1008 may reflect post-counting gain correction performed on charged particle detection counts arising from the charged particle event indicators. In some such embodiments, the post-counting gain correction may be applied to charged particle detection counts aggregated at the pixel level, rather than at the subpixel level; such gain correction may advantageously avoid deteriorating image quality relative to the application of post-counting gain at the subpixel level, as well as requiring less bandwidth and/or storage for storing and using the post-counting gain correction information.

In some embodiments, the output logic 1008 may output information about the defective pixel regions 104 and/or the working pixel regions 108 (e.g., to the data storage 1106 of the CPM system 1110) in addition to the charged particle event indicators. For example, the output logic 1008 may include identification information about the defective pixel regions 104 and/or the working pixel regions 108 (e.g., the locations of defective pixel regions 104 as identified by the pixel identification logic 1002) in headers of data streams that include charged particle event indicators. In another example, the output logic 1008 may provide a first data stream that includes charged particle event indicators and a second, different data stream that includes information about the defective pixel regions 104 and/or the working pixel regions 108. In another example, the pixel identification logic 1002 and/or the output logic 1008 may include identification information about the defective pixel regions 104 and/or the working pixel regions 108 as separate files that can be stored alongside the charged particle event indicators (e.g., in the data storage 1106) or may be otherwise accessed. Such files be provided in any suitable format, such as Extensible Markup Language (XML), JavaScript Object Notation (JSON), or Comma-Separated Value (CSV).

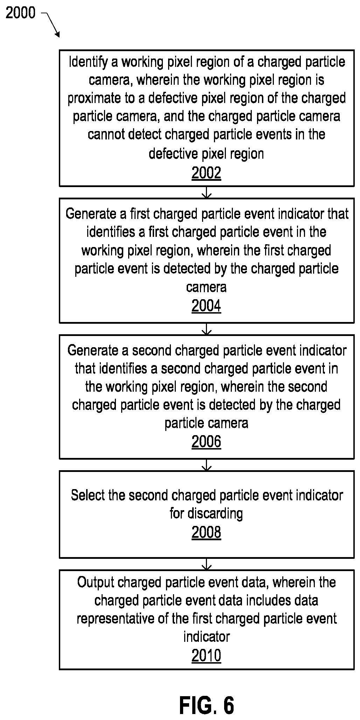

FIGS. 6-9 are flow diagrams of methods of performing CPM support operations, in accordance with various embodiments. Although the operations of the methods of FIGS. 6-9 may be illustrated with reference to particular embodiments disclosed herein (e.g., the CPM support modules 1000 discussed herein with reference to FIG. 1, the GUI 3000 discussed herein with reference to FIG. 10, the computing devices 4000 discussed herein with reference to FIG. 11, and/or the CPM support system 5000 discussed herein with reference to FIG. 12), the methods of FIGS. 6-9 may be used in any suitable setting to perform any suitable CPM support operations. Operations are illustrated once each and in a particular order in FIGS. 6-9, but the operations may be reordered and/or repeated as desired and appropriate (e.g., different operations performed may be performed in parallel, as suitable).

Turning to the method 2000 of FIG. 6, at 2002, a working pixel region of a charged particle camera may be identified. The working pixel region may be proximate to a defective pixel region of the charged particle camera, and the charged particle camera cannot detect charged particle events in the defective pixel region. For example, the pixel identification logic 1002 of a CPM support module 1000 may perform the operations of 2002 in accordance with any of the embodiments disclosed herein.

At 2004, a first charged particle event indicator may be generated that identifies a first charged particle event in the working pixel region. The first charged particle event may be detected by the charged particle camera. For example, the charged particle detection logic 1004 of a CPM support module 1000 may perform the operations of 2004 in accordance with any of the embodiments disclosed herein.

At 2006, a second charged particle event indicator may be generated that identifies a second charged particle event in the working pixel region. The second charged particle event may be detected by the charged particle camera. For example, the charged particle detection logic 1004 of a CPM support module 1000 may perform the operations of 2006 in accordance with any of the embodiments disclosed herein.

At 2008, the second charged particle event indicator may be selected for discarding. For example, the defect masking logic 1006 of a CPM support module 1000 may perform the operations of 2008 in accordance with any of the embodiments disclosed herein.

At 2010, charged particle event data may be output. The charged particle event data may include data representative of the first charged particle event indicator. For example, the output logic 1008 of a CPM support module 1000 may perform the operations of 2010 in accordance with any of the embodiments disclosed herein.

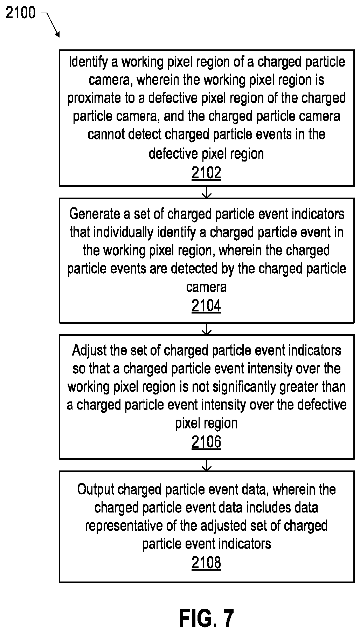

Turning to the method 2100 of FIG. 7, at 2102, a working pixel region of a charged particle camera may be identified. The working pixel region may be proximate to a defective pixel region of the charged particle camera, and the charged particle camera cannot detect charged particle events in the defective pixel region. For example, the pixel identification logic 1002 of a CPM support module 1000 may perform the operations of 2102 in accordance with any of the embodiments disclosed herein.

At 2104, a set of charged particle event indicators that individually identify a charged particle event in the working pixel region may be generated. The charged particle events may be detected by the charged particle camera. For example, the charged particle detection logic 1004 of a CPM support module 1000 may perform the operations of 2104 in accordance with any of the embodiments disclosed herein.

At 2106, the set of charged particle event indicators may be adjusted so that a charged particle event intensity over the working pixel region is not significantly greater than a charged particle event intensity over the defective pixel region. For example, the defect masking logic 1006 of a CPM support module 1000 may perform the operations of 2106 in accordance with any of the embodiments disclosed herein.

At 2108, charged particle event data may be output. The charged particle event data may include data representative of the adjusted set of charged particle event indicators. For example, the output logic 1008 of a CPM support module 1000 may perform the operations of 2108 in accordance with any of the embodiments disclosed herein.

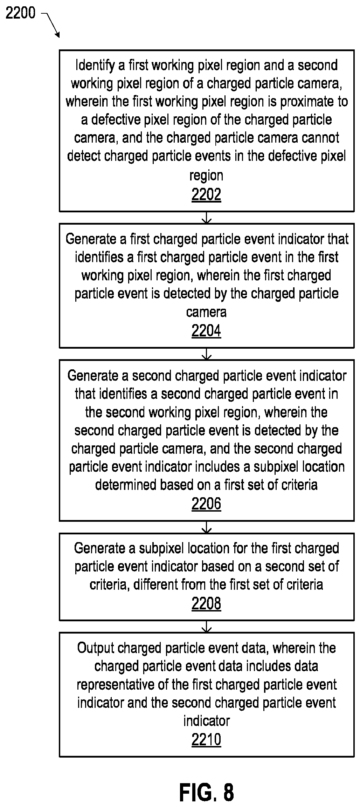

Turning to the method 2200 of FIG. 8, at 2202, a first working pixel region and a second working pixel region of a charged particle camera may be identified. The first working pixel region may be proximate to a defective pixel region of the charged particle camera, and the charged particle camera cannot detect charged particle events in the defective pixel region. For example, the pixel identification logic 1002 of a CPM support module 1000 may perform the operations of 2202 in accordance with any of the embodiments disclosed herein.

At 2204, a first charged particle event indicator that identifies a first charged particle event in the first working pixel region may be generated. The first charged particle event may be detected by the charged particle camera. For example, the charged particle detection logic 1004 of a CPM support module 1000 may perform the operations of 2204 in accordance with any of the embodiments disclosed herein.

At 2206, a second charged particle event indicator that identifies a second charged particle event in the second working pixel region may be generated. The second charged particle event may be detected by the charged particle camera, and the second charged particle event indicator may include a subpixel location determined based on a first set of criteria. For example, the charged particle detection logic 1004 of a CPM support module 1000 may perform the operations of 2206 in accordance with any of the embodiments disclosed herein.

At 2208, a subpixel location for the first charged particle event indicator may be generated based on a second set of criteria, different from the first set of criteria. For example, the defect masking logic 1006 of a CPM support module 1000 may perform the operations of 2208 in accordance with any of the embodiments disclosed herein.

At 2210, charged particle event data may be output. The charged particle event data may include data representative of the first charged particle event indicator and the second charged particle event indicator. For example, the output logic 1008 of a CPM support module 1000 may perform the operations of 2210 in accordance with any of the embodiments disclosed herein.

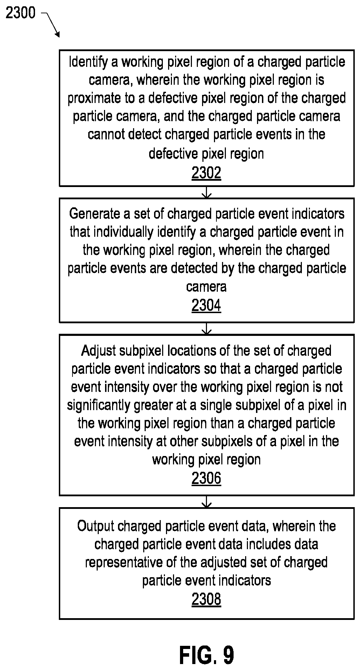

Turning to the method 2300 of FIG. 9, at 2302, a working pixel region of a charged particle camera may be identified. The working pixel region may be proximate to a defective pixel region of the charged particle camera, and the charged particle camera cannot detect charged particle events in the defective pixel region. For example, the pixel identification logic 1002 of a CPM support module 1000 may perform the operations of 2302 in accordance with any of the embodiments disclosed herein.

At 2304, a set of charged particle event indicators may be generated that individually identify a charged particle event in the working pixel region. The charged particle events may be detected by the charged particle camera. For example, the charged particle detection logic 1004 of a CPM support module 1000 may perform the operations of 2304 in accordance with any of the embodiments disclosed herein.

At 2306, subpixel locations of the set of charged particle event indicators may be adjusted so that a charged particle event intensity over the working pixel region is not significantly greater at a single subpixel of a pixel in the working pixel region than a charged particle event intensity at other subpixels of a pixel in the working pixel region. For example, the defect masking logic 1006 of a CPM support module 1000 may perform the operations of 2306 in accordance with any of the embodiments disclosed herein.

At 2308, charged particle event data may be output. The charged particle event data may include data representative of the adjusted set of charged particle event indicators. For example, the output logic 1008 of a CPM support module 1000 may perform the operations of 2308 in accordance with any of the embodiments disclosed herein.

The CPM support methods disclosed herein may include interactions with a human user (e.g., via the user local computing device 5020 discussed herein with reference to FIG. 12). These interactions may include providing information to the user (e.g., information regarding the operation of a CPM such as the CPM 5010 of FIG. 12, information regarding a sample being analyzed or other test or measurement performed by a CPM, information retrieved from a local or remote database, or other information) or providing an option for a user to input commands (e.g., to control the operation of a CPM such as the CPM 5010 of FIG. 12, or to control the analysis of data generated by a CPM), queries (e.g., to a local or remote database), or other information. In some embodiments, these interactions may be performed through a graphical user interface (GUI) that includes a visual display on a display device (e.g., the display device 4010 discussed herein with reference to FIG. 11) that provides outputs to the user and/or prompts the user to provide inputs (e.g., via one or more input devices, such as a keyboard, mouse, trackpad, or touchscreen, included in the other I/O devices 4012 discussed herein with reference to FIG. 11). The CPM support systems disclosed herein may include any suitable GUIs for interaction with a user.

FIG. 10 depicts an example GUI 3000 that may be used in the performance of some or all of the support methods disclosed herein, in accordance with various embodiments. As noted above, the GUI 3000 may be provided on a display device (e.g., the display device 4010 discussed herein with reference to FIG. 11) of a computing device (e.g., the computing device 4000 discussed herein with reference to FIG. 11) of a CPM support system (e.g., the CPM support system 5000 discussed herein with reference to FIG. 12), and a user may interact with the GUI 3000 using any suitable input device (e.g., any of the input devices included in the other I/O devices 4012 discussed herein with reference to FIG. 11) and input technique (e.g., movement of a cursor, motion capture, facial recognition, gesture detection, voice recognition, actuation of buttons, etc.).

The GUI 3000 may include a data display region 3002, a data analysis region 3004, a CPM control region 3006, and a settings region 3008. The particular number and arrangement of regions depicted in FIG. 10 is simply illustrative, and any number and arrangement of regions, including any desired features, may be included in a GUI 3000.

The data display region 3002 may display data generated by a CPM (e.g., the CPM 5010 discussed herein with reference to FIG. 12). For example, the data display region 3002 may display charged particle event indicators output by the output logic 1008 of a CPM support module 1000 and/or CPM output intensity profiles like the CPM output intensity profile 110 of FIG. 4B.

The data analysis region 3004 may display the results of data analysis (e.g., the results of analyzing the data illustrated in the data display region 3002 and/or other data). For example, the data analysis region 3004 may display a reconstruction or other representation of a specimen imaged in accordance with any of the techniques disclosed herein. In some embodiments, the data display region 3002 and the data analysis region 3004 may be combined in the GUI 3000 (e.g., to include data output from a CPM, and some analysis of the data, in a common graph or region).

The CPM control region 3006 may include options that allow the user to control a CPM (e.g., the CPM 5010 discussed herein with reference to FIG. 12). For example, the CPM control region 3006 may include control options to program, start, or stop imaging operations.

The settings region 3008 may include options that allow the user to control the features and functions of the GUI 3000 (and/or other GUIs) and/or perform common computing operations with respect to the data display region 3002 and data analysis region 3004 (e.g., saving data on a storage device, such as the storage device 4004 discussed herein with reference to FIG. 11, sending data to another user, labeling data, etc.). For example, the settings region 3008 may include information about defective pixel regions 104 and/or working pixel regions 108 of the charged particle camera 1102 (e.g., as identified by the pixel identification logic 1002) or controls to allow a user to view and/or change the criteria used by the defect masking logic 1006 when generating "mask" charged particle event indicators in defective pixel regions 104, discarding a fraction of charged particle event indicators in working pixel regions 108, and/or performing subpixel localization for charged particle event indicators in working pixel regions 108).

As noted above, the CPM support module 1000 may be implemented by one or more computing devices. FIG. 11 is a block diagram of a computing device 4000 that may perform some or all of the CPM support methods disclosed herein, in accordance with various embodiments. In some embodiments, the CPM support module 1000 may be implemented by a single computing device 4000 or by multiple computing devices 4000. Further, as discussed below, a computing device 4000 (or multiple computing devices 4000) that implements the CPM support module 1000 may be part of one or more of the CPM 5010, the user local computing device 5020, the service local computing device 5030, or the remote computing device 5040 of FIG. 12.

The computing device 4000 of FIG. 11 is illustrated as having a number of components, but any one or more of these components may be omitted or duplicated, as suitable for the application and setting. In some embodiments, some or all of the components included in the computing device 4000 may be attached to one or more motherboards and enclosed in a housing (e.g., including plastic, metal, and/or other materials). In some embodiments, some these components may be fabricated onto a single system-on-a-chip (SoC) (e.g., an SoC may include one or more processing devices 4002 and one or more storage devices 4004). Additionally, in various embodiments, the computing device 4000 may not include one or more of the components illustrated in FIG. 11, but may include interface circuitry (not shown) for coupling to the one or more components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface) . For example, the computing device 4000 may not include a display device 4010, but may include display device interface circuitry (e.g., a connector and driver circuitry) to which a display device 4010 may be coupled.

The computing device 4000 may include a processing device 4002 (e.g., one or more processing devices). As used herein, the term "processing device" may refer to any device or portion of a device that processes electronic data from registers and/or memory to transform that electronic data into other electronic data that may be stored in registers and/or memory. The processing device 4002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 4000 may include a storage device 4004 (e.g., one or more storage devices). The storage device 4004 may include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 4004 may include memory that shares a die with a processing device 4002. In such an embodiment, the memory may be used as cache memory and may include embedded dynamic random-access memory (eDRAM) or spin transfer torque magnetic random-access memory (STT-MRAM), for example. In some embodiments, the storage device 4004 may include non-transitory computer readable media having instructions thereon that, when executed by one or more processing devices (e.g., the processing device 4002), cause the computing device 4000 to perform any appropriate ones of or portions of the methods disclosed herein.

The computing device 4000 may include an interface device 4006 (e.g., one or more interface devices 4006). The interface device 4006 may include one or more communication chips, connectors, and/or other hardware and software to govern communications between the computing device 4000 and other computing devices. For example, the interface device 4006 may include circuitry for managing wireless communications for the transfer of data to and from the computing device 4000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. Circuitry included in the interface device 4006 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). In some embodiments, circuitry included in the interface device 4006 for managing wireless communications may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 4006 for managing wireless communications may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 4006 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 4006 may include one or more antennas (e.g., one or more antenna arrays) to receipt and/or transmission of wireless communications.

In some embodiments, the interface device 4006 may include circuitry for managing wired communications, such as electrical, optical, or any other suitable communication protocols. For example, the interface device 4006 may include circuitry to support communications in accordance with Ethernet technologies. In some embodiments, the interface device 4006 may support both wireless and wired communication, and/or may support multiple wired communication protocols and/or multiple wireless communication protocols. For example, a first set of circuitry of the interface device 4006 may be dedicated to shorter-range wireless communications such as Wi-Fi or Bluetooth, and a second set of circuitry of the interface device 4006 may be dedicated to longer-range wireless communications such as global positioning system (GPS), EDGE, GPRS, CDMA, WiMAX, LTE, EV-DO, or others. In some embodiments, a first set of circuitry of the interface device 4006 may be dedicated to wireless communications, and a second set of circuitry of the interface device 4006 may be dedicated to wired communications.

The computing device 4000 may include battery/power circuitry 4008. The battery/power circuitry 4008 may include one or more energy storage devices (e.g., batteries or capacitors) and/or circuitry for coupling components of the computing device 4000 to an energy source separate from the computing device 4000 (e.g., AC line power).

The computing device 4000 may include a display device 4010 (e.g., multiple display devices). The display device 4010 may include any visual indicators, such as a heads-up display, a computer monitor, a projector, a touchscreen display, a liquid crystal display (LCD), a light-emitting diode display, or a flat panel display.

The computing device 4000 may include other input/output (I/O) devices 4012. The other I/O devices 4012 may include one or more audio output devices (e.g., speakers, headsets, earbuds, alarms, etc.), one or more audio input devices (e.g., microphones or microphone arrays), location devices (e.g., GPS devices in communication with a satellite-based system to receive a location of the computing device 4000, as known in the art), audio codecs, video codecs, printers, sensors (e.g., thermocouples or other temperature sensors, humidity sensors, pressure sensors, vibration sensors, accelerometers, gyroscopes, etc.), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 4000 may have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra-mobile personal computer, etc.), a desktop computing device, or a server computing device or other networked computing component.

One or more computing devices implementing any of the CPM support modules or methods disclosed herein may be part of a CPM support system. FIG. 12 is a block diagram of an example CPM support system 5000 in which some or all of the CPM support methods disclosed herein may be performed, in accordance with various embodiments. The CPM support modules and methods disclosed herein (e.g., the CPM support module 1000 of FIG. 1 and the methods of FIGS. 6-9) may be implemented by one or more of the CPM 5010, the user local computing device 5020, the service local computing device 5030, or the remote computing device 5040 of the CPM support system 5000.

Any of the CPM 5010, the user local computing device 5020, the service local computing device 5030, or the remote computing device 5040 may include any of the embodiments of the computing device 4000 discussed herein with reference to FIG. 11, and any of the CPM 5010, the user local computing device 5020, the service local computing device 5030, or the remote computing device 5040 may take the form of any appropriate ones of the embodiments of the computing device 4000 discussed herein with reference to FIG. 11.

The CPM 5010, the user local computing device 5020, the service local computing device 5030, or the remote computing device 5040 may each include a processing device 5002, a storage device 5004, and an interface device 5006. The processing device 5002 may take any suitable form, including the form of any of the processing devices 4002 discussed herein with reference to FIG. 5, and the processing devices 5002 included in different ones of the CPM 5010, the user local computing device 5020, the service local computing device 5030, or the remote computing device 5040 may take the same form or different forms. The storage device 5004 may take any suitable form, including the form of any of the storage devices 5004 discussed herein with reference to FIG. 5, and the storage devices 5004 included in different ones of the CPM 5010, the user local computing device 5020, the service local computing device 5030, or the remote computing device 5040 may take the same form or different forms. The interface device 5006 may take any suitable form, including the form of any of the interface devices 4006 discussed herein with reference to FIG. 5, and the interface devices 5006 included in different ones of the CPM 5010, the user local computing device 5020, the service local computing device 5030, or the remote computing device 5040 may take the same form or different forms.

The CPM 5010, the user local computing device 5020, the service local computing device 5030, and the remote computing device 5040 may be in communication with other elements of the CPM support system 5000 via communication pathways 5008. The communication pathways 5008 may communicatively couple the interface devices 5006 of different ones of the elements of the CPM support system 5000, as shown, and may be wired or wireless communication pathways (e.g., in accordance with any of the communication techniques discussed herein with reference to the interface devices 4006 of the computing device 4000 of FIG. 11). The particular CPM support system 5000 depicted in FIG. 12 includes communication pathways between each pair of the CPM 5010, the user local computing device 5020, the service local computing device 5030, and the remote computing device 5040, but this "fully connected" implementation is simply illustrative, and in various embodiments, various ones of the communication pathways 5008 may be absent. For example, in some embodiments, a service local computing device 5030 may not have a direct communication pathway 5008 between its interface device 5006 and the interface device 5006 of the CPM 5010, but may instead communicate with the CPM 5010 via the communication pathway 5008 between the service local computing device 5030 and the user local computing device 5020 and the communication pathway 5008 between the user local computing device 5020 and the CPM 5010.

The user local computing device 5020 may be a computing device (e.g., in accordance with any of the embodiments of the computing device 4000 discussed herein) that is local to a user of the CPM 5010. In some embodiments, the user local computing device 5020 may also be local to the CPM 5010, but this need not be the case; for example, a user local computing device 5020 that is in a user's home or office may be remote from, but in communication with, the CPM 5010 so that the user may use the user local computing device 5020 to control and/or access data from the CPM 5010. In some embodiments, the user local computing device 5020 may be a laptop, smartphone, or tablet device. In some embodiments the user local computing device 5020 may be a portable computing device.

The service local computing device 5030 may be a computing device (e.g., in accordance with any of the embodiments of the computing device 4000 discussed herein) that is local to an entity that services the CPM 5010. For example, the service local computing device 5030 may be local to a manufacturer of the CPM 5010 or to a third-party service company. In some embodiments, the service local computing device 5030 may communicate with the CPM 5010, the user local computing device 5020, and/or the remote computing device 5040 (e.g., via a direct communication pathway 5008 or via multiple "indirect" communication pathways 5008, as discussed above) to receive data regarding the operation of the CPM 5010, the user local computing device 5020, and/or the remote computing device 5040 (e.g., the results of self-tests of the CPM 5010, calibration coefficients used by the CPM 5010, the measurements of sensors associated with the CPM 5010, etc.). In some embodiments, the service local computing device 5030 may communicate with the CPM 5010, the user local computing device 5020, and/or the remote computing device 5040 (e.g., via a direct communication pathway 5008 or via multiple "indirect" communication pathways 5008, as discussed above) to transmit data to the CPM 5010, the user local computing device 5020, and/or the remote computing device 5040 (e.g., to update programmed instructions, such as firmware, in the CPM 5010, to initiate the performance of test or calibration sequences in the CPM 5010, to update programmed instructions, such as software, in the user local computing device 5020 or the remote computing device 5040, etc.). A user of the CPM 5010 may utilize the CPM 5010 or the user local computing device 5020 to communicate with the service local computing device 5030 to report a problem with the CPM 5010 or the user local computing device 5020, to request a visit from a technician to improve the operation of the CPM 5010, to order consumables or replacement parts associated with the CPM 5010, or for other purposes.

The remote computing device 5040 may be a computing device (e.g., in accordance with any of the embodiments of the computing device 4000 discussed herein) that is remote from the CPM 5010 and/or from the user local computing device 5020. In some embodiments, the remote computing device 5040 may be included in a datacenter or other large-scale server environment. In some embodiments, the remote computing device 5040 may include network-attached storage (e.g., as part of the storage device 5004). The remote computing device 5040 may store data generated by the CPM 5010, perform analyses of the data generated by the CPM 5010 (e.g., in accordance with programmed instructions), facilitate communication between the user local computing device 5020 and the CPM 5010, and/or facilitate communication between the service local computing device 5030 and the CPM 5010.

In some embodiments, one or more of the elements of the CPM support system 5000 illustrated in FIG. 12 may not be present. Further, in some embodiments, multiple ones of various ones of the elements of the CPM support system 5000 of FIG. 12 may be present. For example, a CPM support system 5000 may include multiple user local computing devices 5020 (e.g., different user local computing devices 5020 associated with different users or in different locations). In another example, a CPM support system 5000 may include multiple CPMs 5010, all in communication with service local computing device 5030 and/or a remote computing device 5040; in such an embodiment, the service local computing device 5030 may monitor these multiple CPMs 5010, and the service local computing device 5030 may cause updates or other information may be "broadcast" to multiple CPMs 5010 at the same time. Different ones of the CPMs 5010 in a CPM support system 5000 may be located close to one another (e.g., in the same room) or farther from one another (e.g., on different floors of a building, in different buildings, in different cities, etc.). In some embodiments, a CPM 5010 may be connected to an Internetof-Things (IoT) stack that allows for command and control of the CPM 5010 through a web-based application, a virtual or augmented reality application, a mobile application, and/or a desktop application. Any of these applications may be accessed by a user operating the user local computing device 5020 in communication with the CPM 5010 by the intervening remote computing device 5040. In some embodiments, a CPM 5010 may be sold by the manufacturer along with one or more associated user local computing devices 5020 as part of a local CPM computing unit 5012.

For the purposes of the present disclosure, the phrases "A and/or B" and "A or B" mean (A), (B), or (A and B). For the purposes of the present disclosure, the phrases "A, B, and/or C" and "A, B, or C" mean (A), (B), (C), (A and B), (A and C), (B and C), or (A, B, and C). Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices.

The description uses the phrases "an embodiment," "various embodiments," and "some embodiments," each of which may refer to one or more of the same or different embodiments. Furthermore, the terms "comprising," "including," "having," and the like, as used with respect to embodiments of the present disclosure, are synonymous. When used to describe a range of dimensions, the phrase "between X and Y" represents a range that includes X and Y. As used herein, an "apparatus" may refer to any individual device, collection of devices, part of a device, or collections of parts of devices. The drawings are not necessarily to scale.

## Claims

1. A charged particle microscope support apparatus, comprising:
first logic to identify a working pixel region of a charged particle camera, wherein the working pixel region is proximate to a defective pixel region of the charged particle camera, and the charged particle camera cannot detect charged particle events in the defective pixel region wherein the charged particle events cause charge carriers to be generated across an area of the charged particle camera;
second logic to (1) generate a first charged particle event indicator that identifies a time and a location of a first charged particle event in the working pixel region, wherein the first charged particle event is detected by the charged particle camera, and (2) generate a second charged particle event indicator that identifies a time and a location of a second charged particle event in the working pixel region, wherein the second charged particle event is detected by the charged particle camera;
third logic to select the second charged particle event indicator for discarding; and
fourth logic to output charged particle event data, wherein the charged particle event data includes data representative of the first charged particle event indicator.

2. The charged particle microscope support apparatus of claim 1, wherein the charged particle event data does not include data representative of the second charged particle event indicator.

3. The charged particle microscope support apparatus of claim 1, wherein the charged particle event data includes data representative of the second charged particle event indicator, and also includes an indicator that the second charged particle event indicator has been selected for discarding.

4. The charged particle microscope support apparatus of claim 1, wherein the third logic is to select the second charged particle event indicator for discarding probabilistically.

5. The charged particle microscope support apparatus of claim 4, wherein the third logic is to select the second charged particle event indicator for discarding probabilistically based at least in part on an expected rate of charged particle events detected by the charged particle camera.

6. The charged particle microscope support apparatus of claim 1, wherein the working pixel region is adjacent to the defective pixel region.

7. The charged particle microscope support apparatus of claim 1, wherein the third logic is to select a fraction of charged particle event indicators associated with the working pixel region for discarding.

8. The charged particle microscope support apparatus of claim 7, wherein the third logic is to select the fraction probabilistically.

9. The charged particle microscope support apparatus of any of claims 1-8, wherein the third logic is to generate a subpixel location for the first charged particle event indicator.

10. The charged particle microscope support apparatus of claim 9, wherein the third logic is to generate the subpixel location for the first charged particle event indicator probabilistically over all subpixels of a pixel associated with the first charged particle event indicator.

11. The charged particle microscope support apparatus of claim 9, wherein the third logic is to generate the subpixel location uniformly over all subpixels of a pixel associated with the first charged particle event indicator.

12. The charged particle microscope support apparatus of any of claims 1-8, wherein the third logic is to generate one or more charged particle event indicators for the defective pixel region.

13. The charged particle microscope support apparatus of any of claims 1-8, wherein the defective pixel region is a region outside a border of a pixel array of the charged particle camera.

14. A method of supporting a charged particle microscope, comprising:
identifying a working pixel region of a charged particle camera, wherein the working pixel region is proximate to a defective pixel region of the charged particle camera, and the charged particle camera cannot detect charged particle events in the defective pixel region wherein the charged particle events cause charge carriers to be generated across an area of the charged particle camera;
generating a first charged particle event indicator that identifies a time and a location of a first charged particle event in the working pixel region, wherein the first charged particle event is detected by the charged particle camera;
generating a second charged particle event indicator that identifies a time and a location of a second charged particle event in the working pixel region, wherein the second charged particle event is detected by the charged particle camera;
selecting the second charged particle event indicator for discarding; and
outputting charged particle event data, wherein the charged particle event data includes data representative of the first charged particle event indicator.

15. A charged particle microscope, comprising:
a support apparatus, including logic to:
identify a working pixel region of a charged particle camera, wherein the working pixel region is proximate to a defective pixel region of the charged particle camera, and the charged particle camera cannot detect charged particle events in the defective pixel region wherein the charged particle events cause charge carriers to be generated across an area of the charged particle camera;
generate a first charged particle event indicator that identifies a time and a location of a first charged particle event in the working pixel region, wherein the first charged particle event is detected by the charged particle camera;
generate a second charged particle event indicator that identifies a time and a location of a second charged particle event in the working pixel region, wherein the second charged particle event is detected by the charged particle camera; select the second charged particle event indicator for discarding; and
output charged particle event data, wherein the charged particle event data includes data representative of the first charged particle event indicator.

## Patentansprüche

1. Einrichtung zur Unterstützung eines Ladungsteilchenmikroskops, umfassend:
erste Logik zum Identifizieren eines funktionierenden Pixelbereichs einer Ladungsteilchenkamera, wobei der funktionierende Pixelbereich in der Nähe eines defekten Pixelbereichs der Ladungsteilchenkamera liegt und die Ladungsteilchenkamera keine Ladungsteilchenereignisse in dem defekten Pixelbereich erkennen kann, wobei die Ladungsteilchenereignisse dazu führen, dass Ladungsträger über einen Bereich der Ladungsteilchenkamera erzeugt werden;
zweite Logik zum (1) Erzeugen eines ersten Ladungsteilchenereignisindikators, der eine Zeit und einen Ort eines ersten Ladungsteilchenereignisses in dem funktionierenden Pixelbereich identifiziert, wobei das erste Ladungsteilchenereignis durch die Ladungsteilchenkamera erkannt wird, und (2) Erzeugen eines zweiten Ladungsteilchenereignisindikators, der eine Zeit und einen Ort eines zweiten Ladungsteilchenereignisses in dem funktionierenden Pixelbereich identifiziert, wobei das zweite Ladungsteilchenereignis durch die Ladungsteilchenkamera erkannt wird;
dritte Logik zum Auswählen des zweiten Ladungsteilchenereignisindikators zum Verwerfen; und
vierte Logik zum Ausgeben von Ladungsteilchenereignisdaten, wobei die Ladungsteilchenereignisdaten Daten einschließen, die den ersten Ladungsteilchenereignisindikator darstellen.

2. Einrichtung zur Unterstützung eines Ladungsteilchenmikroskops nach Anspruch 1, wobei die Ladungsteilchenereignisdaten keine Daten einschließen, die den zweiten Ladungsteilchenereignisindikator darstellen.

3. Einrichtung zur Unterstützung eines Ladungsteilchenmikroskops nach Anspruch 1, wobei die Ladungsteilchenereignisdaten Daten einschließen, die den zweiten Ladungsteilchenereignisindikator darstellen, und außerdem einen Indikator einschließen, der besagt, dass der zweite Ladungsteilchenereignisindikator zum Verwerfen ausgewählt wurde.

4. Einrichtung zur Unterstützung eines Ladungsteilchenmikroskops nach Anspruch 1, wobei die dritte Logik dazu dient, den zweiten Ladungsteilchenereignisindikator zum Verwerfen probabilistisch auszuwählen.

5. Einrichtung zur Unterstützung eines Ladungsteilchenmikroskops nach Anspruch 4, wobei die dritte Logik dazu dient, den zweiten Ladungsteilchenereignisindikator zum Verwerfen probabilistisch auszuwählen, und zwar zumindest teilweise basierend auf einer erwarteten Rate von Ladungsteilchenereignissen, die von der Ladungsteilchenkamera erkannt werden.

6. Einrichtung zur Unterstützung eines Ladungsteilchenmikroskops nach Anspruch 1, wobei der funktionierende Pixelbereich an den defekten Pixelbereich angrenzt.

7. Einrichtung zur Unterstützung eines Ladungsteilchenmikroskops nach Anspruch 1, wobei die dritte Logik dazu dient, einen Anteil der Ladungsteilchenereignisindikatoren, die dem funktionierenden Pixelbereich zugehörig sind, zum Verwerfen auszuwählen.

8. Einrichtung zur Unterstützung eines Ladungsteilchenmikroskops nach Anspruch 7, wobei die dritte Logik dazu dient, den Anteil probabilistisch auszuwählen.

9. Einrichtung zur Unterstützung eines Ladungsteilchenmikroskops nach einem der Ansprüche 1 bis 8, wobei die dritte Logik dazu dient, eine Subpixelposition für den ersten Ladungsteilchenereignisindikator zu erzeugen.

10. Einrichtung zur Unterstützung eines Ladungsteilchenmikroskops nach Anspruch 9, wobei die dritte Logik dazu dient, die Subpixelposition für den ersten Ladungsteilchenereignisindikator probabilistisch über alle Subpixel eines Pixels zu erzeugen, das dem ersten Ladungsteilchenereignisindikator zugehörig ist.

11. Einrichtung zur Unterstützung eines Ladungsteilchenmikroskops nach Anspruch 9, wobei die dritte Logik dazu dient, die Subpixelposition gleichmäßig über alle Subpixel eines Pixels zu erzeugen, das dem ersten Ladungsteilchenereignisindikator zugehörig ist.

12. Einrichtung zur Unterstützung eines Ladungsteilchenmikroskops nach einem der Ansprüche 1 bis 8, wobei die dritte Logik dazu dient, einen oder mehrere Ladungsteilchenereignisindikatoren für den defekten Pixelbereich zu erzeugen.

13. Einrichtung zur Unterstützung eines Ladungsteilchenmikroskops nach einem der Ansprüche 1 bis 8, wobei der defekte Pixelbereich ein Bereich außerhalb einer Grenze eines Pixelarrays der Ladungsteilchenkamera ist.

14. Verfahren zum Unterstützen eines Ladungsteilchenmikroskops, umfassend:
Identifizieren eines funktionierenden Pixelbereichs einer Ladungsteilchenkamera, wobei der funktionierende Pixelbereich in der Nähe eines defekten Pixelbereichs der Ladungsteilchenkamera liegt und die Ladungsteilchenkamera keine Ladungsteilchenereignisse in dem defekten Pixelbereich erkennen kann, wobei die Ladungsteilchenereignisse dazu führen, dass Ladungsträger über einen Bereich der Ladungsteilchenkamera erzeugt werden;
Erzeugen eines ersten Ladungsteilchenereignisindikators, der eine Zeit und einen Ort eines ersten Ladungsteilchenereignisses in dem funktionierenden Pixelbereich identifiziert, wobei das erste Ladungsteilchenereignis durch die Ladungsteilchenkamera erkannt wird;
Erzeugen eines zweites Ladungsteilchenereignisindikators, der eine Zeit und einen Ort eines zweiten Ladungsteilchenereignisses in dem funktionierenden Pixelbereich identifiziert, wobei das zweite Ladungsteilchenereignis durch die Ladungsteilchenkamera erkannt wird;
Auswählen des zweiten Ladungsteilchenereignisindikators zum Verwerfen; und
Ausgeben von Ladungsteilchenereignisdaten, wobei die Ladungsteilchenereignisdaten Daten einschließen, die den ersten Ladungsteilchenereignisindikator darstellen.

15. Ladungsteilchenmikroskop, umfassend:
eine Einrichtung zur Unterstützung, einschließlich Logik zum:
Identifizieren eines funktionierenden Pixelbereichs einer Ladungsteilchenkamera, wobei der funktionierende Pixelbereich in der Nähe eines defekten Pixelbereichs der Ladungsteilchenkamera liegt und die Ladungsteilchenkamera keine Ladungsteilchenereignisse in dem defekten Pixelbereich erkennen kann, wobei die Ladungsteilchenereignisse dazu führen, dass Ladungsträger über einen Bereich der Ladungsteilchenkamera erzeugt werden;
Erzeugen eines ersten Ladungsteilchenereignisindikators, der eine Zeit und einen Ort eines ersten Ladungsteilchenereignisses in dem funktionierenden Pixelbereich identifiziert, wobei das erste Ladungsteilchenereignis durch die Ladungsteilchenkamera erkannt wird;
Erzeugen eines zweites Ladungsteilchenereignisindikators, der eine Zeit und einen Ort eines zweiten Ladungsteilchenereignisses in dem funktionierenden Pixelbereich identifiziert, wobei das zweite Ladungsteilchenereignis durch die Ladungsteilchenkamera erkannt wird; Auswählen des zweiten Ladungsteilchenereignisindikators zum Verwerfen; und
Ausgeben von Ladungsteilchenereignisdaten, wobei die Ladungsteilchenereignisdaten Daten einschließen, die den ersten Ladungsteilchenereignisindikator darstellen.

## Revendications

1. Appareil de support de microscope à particules chargées, comprenant :
une première logique pour identifier une région de pixels fonctionnels d'une caméra à particules chargées, dans lequel la région de pixels fonctionnels est à proximité d'une région de pixels défectueux de la caméra à particules chargées, et la caméra à particules chargées ne peut pas détecter des événements de particules chargées dans la région de pixels défectueux, dans lequel les événements de particules chargées provoquent la génération de porteurs de charge sur une zone de la caméra à particules chargées ;
une deuxième logique pour (1) générer un premier indicateur d'événement de particules chargées qui identifie un moment et un emplacement d'un premier événement de particules chargées dans la région de pixels fonctionnels, dans lequel le premier événement de particules chargées est détecté par la caméra à particules chargées, et (2) générer un second indicateur d'événement de particules chargées qui identifie un moment et un emplacement d'un second événement de particules chargées dans la région de pixels fonctionnels, dans lequel le second événement de particules chargées est détecté par la caméra à particules chargées ;
une troisième logique pour sélectionner le second indicateur d'événement de particules chargées pour élimination ; et
une quatrième logique pour délivrer en sortie des données d'événements de particules chargées, dans lequel les données d'événements de particules chargées comportent des données représentatives du premier indicateur d'événement de particules chargées.

2. Appareil de support de microscope à particules chargées selon la revendication 1, dans lequel les données d'événement de particules chargées ne comportent pas de données représentant le second indicateur d'événement de particules chargées.

3. Appareil de support de microscope à particules chargées selon la revendication 1, dans lequel les données d'événement de particules chargées comportent des données représentant le second indicateur d'événement de particules chargées, et comportent également un indicateur que le second indicateur d'événement de particules chargées a été sélectionné pour élimination.

4. Appareil de support de microscope à particules chargées selon la revendication 1, dans lequel la troisième logique consiste à sélectionner le second indicateur d'événement de particules chargées à éliminer de manière probabiliste.

5. Appareil de support de microscope à particules chargées selon la revendication 4, dans lequel la troisième logique consiste à sélectionner le second indicateur d'événement de particules chargées à éliminer de manière probabiliste, sur la base d'au moins en partie un taux attendu d'événements de particules chargées détectés par la caméra à particules chargées.

6. Appareil de support de microscope à particules chargées selon la revendication 1, dans lequel la région de pixels fonctionnels est adjacente à la région de pixels défectueux.

7. Appareil de support de microscope à particules chargées selon la revendication 1, dans lequel la troisième logique consiste à sélectionner une fraction d'indicateurs d'événements de particules chargées associés à la région de pixels fonctionnels pour élimination.

8. Appareil de support de microscope à particules chargées selon la revendication 7, dans lequel la troisième logique consiste à sélectionner la fraction de manière probabiliste.

9. Appareil de support de microscope à particules chargées selon l'une quelconque des revendications 1 à 8, dans lequel la troisième logique consiste à générer un emplacement de sous-pixel pour le premier indicateur d'événement de particules chargées.

10. Appareil de support de microscope à particules chargées selon la revendication 9, dans lequel la troisième logique consiste à générer l'emplacement de sous-pixel pour le premier indicateur d'événement de particules chargées de manière probabiliste sur tous les sous-pixels d'un pixel associé au premier indicateur d'événement de particules chargées.

11. Appareil de support de microscope à particules chargées selon la revendication 9, dans lequel la troisième logique consiste à générer l'emplacement de sous-pixel uniformément sur tous les sous-pixels d'un pixel associé au premier indicateur d'événement de particules chargées.

12. Appareil de support de microscope à particules chargées selon l'une quelconque des revendications 1 à 8, dans lequel la troisième logique consiste à générer un ou plusieurs indicateurs d'événement de particules chargées pour la région de pixels défectueux.

13. Appareil de support de microscope à particules chargées selon l'une quelconque des revendications 1 à 8, dans lequel la région de pixels défectueux est une région située à l'extérieur d'une bordure d'un réseau de pixels de la caméra à particules chargées.

14. Procédé de support d'un microscope à particules chargées, comprenant :
l'identification d'une région de pixels utiles d'une caméra à particules chargées, dans lequel la région de pixels fonctionnels est proche d'une région de pixels défectueux de la caméra à particules chargées, et la caméra à particules chargées ne peut pas détecter des événements de particules chargées dans la région de pixels défectueux, dans lequel les événements de particules chargées provoquent la génération de porteurs de charge à travers une zone de la caméra à particules chargées ;
la génération d'un premier indicateur d'événement de particules chargées qui identifie une moment et un emplacement d'un premier événement de particules chargées dans la région de pixels fonctionnels, dans lequel le premier événement de particules chargées est détecté par la caméra à particules chargées ;
la génération d'un second indicateur d'événement de particules chargées qui identifie un moment et un emplacement d'un deuxième événement de particules chargées dans la région de pixels fonctionnels, dans lequel le deuxième événement de particules chargées est détecté par la caméra à particules chargées ;
la sélection d'un second indicateur d'événement de particules chargées à éliminer ; et
l'émission de données relatives à l'événement de particules chargées, dans lequel les données relatives à l'événement de particules chargées comportent des données représentatives du premier indicateur d'événement de particules chargées.

15. Microscope à particules chargées, comprenant :
un appareil de support, comportant une logique pour :
identifier une région de pixels fonctionnels d'une caméra à particules chargées, dans lequel la région de pixels fonctionnels est proche d'une région de pixels défectueux de la caméra à particules chargées, et la caméra à particules chargées ne peut pas détecter des événements de particules chargées dans la région de pixels défectueux, dans lequel les événements de particules chargées provoquent la génération de porteurs de charge à travers une zone de la caméra à particules chargées ;
la génération d'un premier indicateur d'événement de particules chargées qui identifie une heure et un emplacement d'un premier événement de particules chargées dans la région de pixels fonctionnels, dans lequel le premier événement de particules chargées est détecté par la caméra à particules chargées ;
la génération d'un second indicateur d'événement de particules chargées qui identifie une heure et un emplacement d'un deuxième événement de particules chargées dans la région de pixels fonctionnels, dans lequel le deuxième événement de particules chargées est détecté par la caméra à particules chargées ; la sélection du second indicateur d'événement de particules chargées pour élimination ; et
le fait de délivrer en sortie des données d'événement de particules chargées, dans lequel les données d'événement de particules chargées comportent des données représentatives du premier indicateur d'événement de particules chargées.
